# EUROPÄISCHE PATENTANMELDUNG

(11) **EP 1 191 339 A2**
(43) Veröffentlichungstag der Anmeldung: **27.03.2002**
(21) Anmeldenummer: 01122094.4
(22) Anmeldetag: 14.09.2001
(51) Int. Cl.: G01R 19/00, H02P 7/28

(54) **Verfahren zur Erfassung eines durch eine Last fliessenden impulsförmigen Stromes**

(30) Priorität: 18.09.2000 DE 10046393
(71) Anmelder: SIEMENS AKTIENGESELLSCHAFT, 80333 München (DE)
(72) Erfinder: Hadamik, Matthias, 61348 Bad Homburg (DE)

(57) **Zusammenfassung**

Die Erfindung betrifft ein Verfahren zur Erfassung eines durch eine Last fließenden impulsförmigen Stromes, bei welchem als Meßimpuls ein Spannungsabfall über einen von dem impulsförmigen Strom durchflossenen Meßwiderstand ausgewertet wird.

Bei einem Verfahren, bei welchem unter Beibehaltung des ferromagnetischen Verhaltens des Meßwiderstandes ein korrektes Meßsignal erzeugt wird, besitzt der Strom bipolare Stromrichtungen, wobei vor Beginn der Strommessungen mindestens ein Vorsteuerstromimpuls (V1, V2, V3) an dem aus einem magnetischen Material bestehenden Meßwiderstand (6) anliegt, welcher die Stromrichtung der während der Strommessung auftretenden Stromimpulse (Iₘₑₛₛ) aufweist, wobei die Amplitude des Vorsteuerstromimpulses (V1, V2, V3) annähernd einem Maximalwert des zu messenden Stromimpulses (Iₘₑₛₛ) entspricht und die Pulsbreite des Vorsteuerstromimpulses (V1, V2, V3) kleiner ist als die Pulsbreite des Meßimpulses (Uₘₑₛₛ).

## Beschreibung

Die Erfindung betrifft ein Verfahren zur Erfassung eines durch eine Last fließenden impulsförmigen Stromes, bei welchem als Meßimpuls ein Spannungsabfall über einem von dem impulsförmigen Strom durchflossenen Meßwiderstand ausgewertet wird.

Bei der Messung von impulsförmigen Strömen in einem Steuergerät für ein Kraftfahrzeug kommt es an Meßwiderständen, welche ein ferromagnetisches Verhalten ausweisen, bei Änderung der Bestromungsrichtung zu extremen Störungen des Meßsignales. Wird ein Stromimpuls in umgekehrter Richtung als es für den Meßstrom vorgesehen ist, durch den Shunt geschickt, kommt es zu einer Ummagnetisierung des Materials. Während dieser Magnetisierungsvorgänge steigt die Induktivität der Shunts erheblich an. Die daraus resultierenden Störungen können so stark werden, dass sie die Größenordnung des auszuwertenden Nutzsignales übersteigen, was in der angeschlossenen Auswerteschaltung zu Fehlinterpretationen führt.

Dieses Problem ließ sich bisher nur durch die Verwendung von teuren Meßshunts lösen, welche aus nicht ferromagnetischem Material bestehen, deren Einsatz aber auf Grund unterschiedlicher Ausdehnungskoeffizienten nicht auf allen Bauträgermaterialien möglich ist.

Der Erfindung- liegt somit die Aufgabe zugrunde, ein Verfahren zur Erfassung eines durch eine Last fließenden impulsförmigen Stromes anzugeben, bei welchem unter Beibehaltung des ferromagnetischen Verhaltens des Meßwiderstandes ein korrektes Meßsignal erzeugt wird.

Erfindungsgemäß wird die Aufgabe dadurch gelöst, dass der Strom bipolare Stromrichtungen aufweist und vor Beginn der Strommessung mindestens ein Vorsteuerstromimpuls an dem aus magnetischen Material bestehenden Meßwiderstand anliegt, welcher die Stromrichtung der während der Strommessung auftretenden Stromimpulse aufweist, wobei die Amplitude des Vorstromimpulses annähernd einem Maximalwert des zu messenden Stromimpulses entspricht und die Pulsbreite des Vorsteuerstromimpulses kleiner ist als die Pulsbreite des Meßimpulses.

Die Erfindung hat den Vorteil, dass durch die gezielte Ummagnetisierung des Meßshunts der schädliche Einfluß der Bauteileigenschaften eliminiert und die beschriebenen negativen Meßfehler unterdrückt werden. Auf eine Änderung des Endstufendesigns (Brückenschaltung) kann verzichtet werden. Der als Vorsteuerstromimpuls bezeichnete Ummagnetisierungsimpuls muß so stark sein, dass er das Shuntmaterial, welches durch einen durch reversiblen Stromfluß verursachten Rückwärtsimpuls in eine andere Magnetisierungsrichtung gedrängt wurde, wieder die Magnetisierungsrichtung annimmt, welche für die Strommessung notwendig ist. Aufgrund der Verwendung von Meßwiderständen mit ferromagnetischen Eigenschaften ist der Einsatz des Shunts auf einem Keramiksubstrat möglich.

In einer Ausgestaltung der Erfindung ist die Pulsbreite des Vorsteuerstromimpulses kleiner als die Summe der ansteigenden und der abfallenden Flanke des von einem Enstufentrieber ausgegebenen Impulses.

Damit die kurzen Impulse keine kritische Signalspannung am Meßverstärker generieren können, wird das Meßsignal, welches infolge des Vorsteuerstromimpulses oder des Netzstromimpulses gemessen wird, integriert. Auf Grund dieser Integration am Eingang des Meßverstärkers wird eine Triggerung des Ausgangssignals des Meßverstärkers unterbunden.

Da ein einzelner kurzer Vorsteuerstromimpuls für die Ummagnetisierung des Shunts meistens nicht ausreichend ist, wird in einer Weiterbildung der Erfindung vorgeschlagen, daß mehrere Vorsteuerstromimpulse mit unterschiedlichen Impulsbreiten erzeugt werden, wobei die Amplitude des letzen Vorsteuerstromimpulses dem Maximalstrom, welcher durch den Meßwiderstand fließt, entspricht. Aufgrund dieser Verfahrensweise weist der reguläre zu messende Stromimpuls keine durch die Ummagnetisierungen hervorgerufenen Verformungen auf, so dass das Meßsignal am Ausgang des Meßverstärkers vorbehaltlos ausgewertet werden kann.

Alternativ weisen mehrere Vorsteuerstromimpulse annähernd die gleiche Impulsbreite und die gleiche Amplitude auf. Diese Lösung stellt ein praktisch gut durchzuführendes Verfahren dar. Der Zeitpunkt der Ummagnetisierung liegt zwischen dem Ende einer Nullbestromungsphase und dem Beginn einer Bestromungsphase der als Elektromotor ausgebildeten Last.

Vorteilhafterweise wird die Amplitude jedes Meßimpulses zur Prüfung des Fehlerfalles ausgewertet, wobei bei Feststellung des Fehlerfalles die Last abgeschaltet wird. Die Pausen zwischen den einzelnen Vorsteuerstromimpulsen sind prinzipiell egal, im Hinblick auf die nachfolgende Filterung des Signals müssen aber ausreichende Pausen zwischen den einzelnen Impulsen liegen, um ein Aufintegrieren zu verhindern.

Die Erfindung läßt zahlreiche Ausführungsformen zu. Eine davon soll anhand der in der Zeichnung dargestellten Figuren näher erläutert werden.

Es zeigt:
- Figur 1: Blockschaltbild einer Strommeßeinrichtung
- Figur 2: Zeitdiagramme

Gleiche Merkmale sind mit gleichen Bezugszeichen gekennzeichnet.

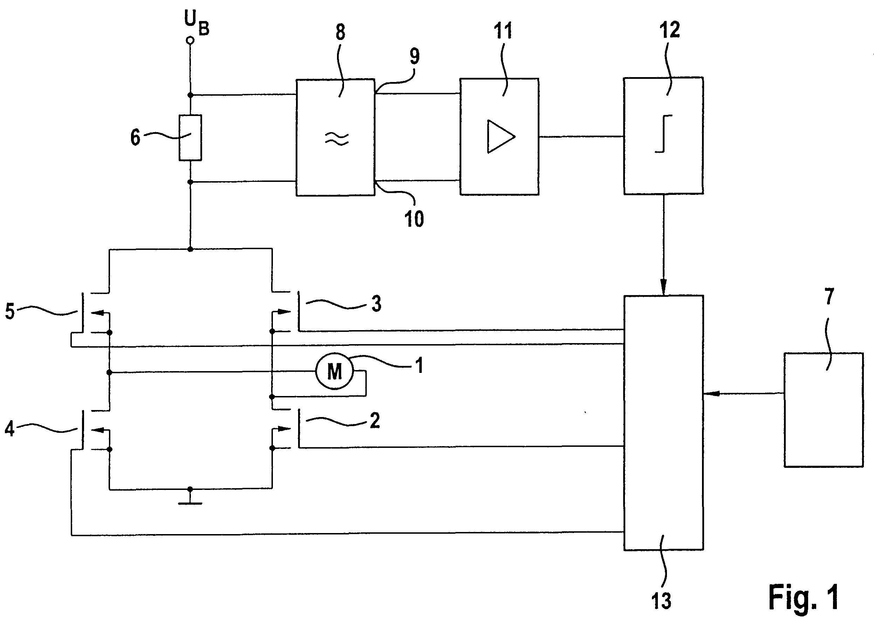

In Figur 1 ist der prinzipielle Aufbau einer Meßeinrichtung dargestellt, welche den Ansteuerstrom eines Elektromotor mißt, wobei der Elektromotor den Ventilhub eines Lufteinlaßventiles eines Verbrennungsmotors einstellt. Der Elektromotor 1 wird dabei von einer Endstufe angesteuert, welche als Brückenendstufe bestehend aus den Transistoren 2, 3, 4, 5 aufgebaut ist. Über einen Meßshunt 6 der beispielsweise aus Aluminiumchrom besteht, ist die Endstufe 2, 3, 4, 5 mit Betriebsspannung U_{B} verbunden. Über dem Meßwiderstand 6 greift ein Hochpassfilter 8 das Meßsignal Uₘₑₛₛ ab. Die Ausgänge 9, 10 des Hochpaßfilters 8 sind an einen Endverstärker 11 angekoppelt. Der Ausgang des Endverstärkers 11 wird einem Schaltelement 12, vorzugsweise einem Komparator zugeführt, welches bei Überschreiten eines vorgegebenen Schwellwertes die Motorendstufe 2, 3, 4, 5 abschaltet.

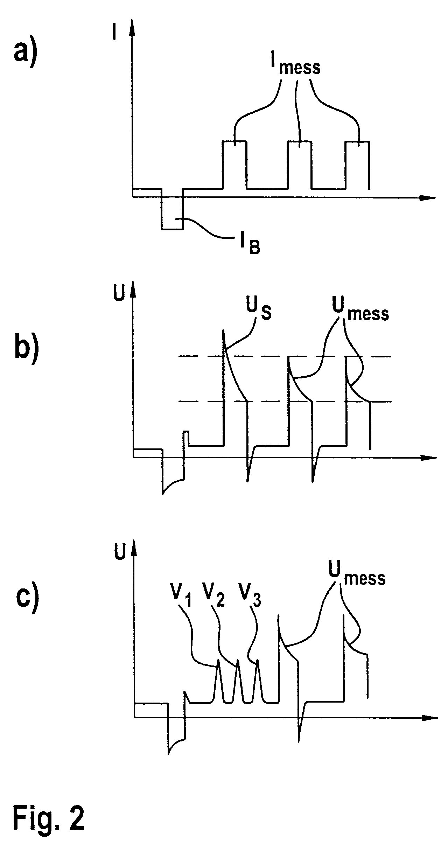

Der von einem Mikroprozessor 7 angesteuerte Endstufentreiber 13 erzeugt am Shunt 6 einen rechteckförmigen Strom Iₘₑₛₛ, wie er in Figur 2a dargestellt ist. Dieser rechteckförmige Strom I wird mit Hilfe des Widerstandes 6 erfaßt. Im vorliegenden Einsatzfall muß der Meßwiderstand 6 Stromimpulse Iₘₑₛₛ mit einer Amplitude bis zu 150 Ampére erfassen können, welche bei der Ansteuerung der Motorendstufe 2, 3, 4, 5 entsteht. Wird die Bestromungsrichtung im Shunt 6 geändert, was beispielsweise beim Abbremsen des Motors 1 auftritt, fließt ein in der Figur 2 a darstellter negativer Rückspeisestromimpuls I_{B} welcher die Größe eines Meßimpulses Iₘₑₛₛ aufweist. Dabei wird der Meßwiderstand 6 aufgrund seines ferromagnetischen Materialverhaltens ummagnetisiert. Er stellt nach der Ummagnetisierung eine deutlich größere Induktivität dar, welche sich als deutlich größere Störung im Meßsignal U zeigt.

Das Meßsignal U, welches am Meßverstärker 11 ausgegeben wird, ist in der Figur 2 b dargestellt. Der Rückspeiseimpuls I_{B}, welcher aufgrund des Sperrens der Transistoren 2, 3, 4, 5 in den Meßwiderstand 6 geleitet wird, führt am Ausgang des Meßverstärkers 11 zu der beschriebenen Störung U_{S} des Meßimpulses U_{meß} mit einer sehr großen Impulsspitze. Der nachfolgende Komparator 12 detektiert bei einer Einzelimpulsauswertung die infolge der Ummagnetisierung des Meßwiderstandes 6 entstandene Stromspitze U_{S} und würde dies als Fehler erkennen und die Endstufe 2, 3, 4, 5 abschalten.

Um dies zu verhindern, werden gemäß Figur 2 c unmittelbar vor Beginn der eigentlichen Messung durch den den Enstufentreiber 13 ansteuernden Mikroprozessor 7 drei Vorstromimpulse V1, V2, V3 in die Motoransteuerung eingefügt, welche eine Einschaltdauer von 2 Mikrosekunden haben. Diese Stromimpulse V1, V2, V3 erzwingen eine erneute Ummagnetisierung des Messwiderstandes 6 in seine ursprüngliche Magnetisierungsrichtung, so daß die Vorzugsstromrichtung, wie sie für den Messfall notwendig ist, wieder hergestellt wird.

Die Impulsbreite jedes einzelnen Vorsteuerimpulses V1, V2, V3 ist dabei so gewählt, daß sie von dem Hochpass 8 nicht erkannt und somit ausgefiltert wird. Vorteilhafterweise ist die Impulsbreite der Vorsteuerimpulse V1, V2, V3 kürzer als die Summe der ansteigenden und der abfallenden Flanke des Endstufentreibers 11. Die im Endstufentreiber 11 eingestellte Impulsbreite und Flankensteilheit setzt sich über die Motorendstufe 2, 3, 4, 5 bis hin zum Stromanstieg über dem Meßshunt 6 fort. Dadurch sind diese Flanken des vom Endstufentreiber 11 abgegebenen Impulses auch am Endverstärker 11 sichtbar.

Darüber hinaus ist die Amplitude jedes einzelnen Vorsteuerimpulses V1, V2, V3 annähernd genauso groß wie der Maximalwert I_{Max} des anzusteuernden Stromes Iₘₑₛₛ. Auf diese Weise wird eine Rückmagnetisierung in die bevorzugte Stromrichtung erreicht und die Strommessung kann aufgrund dieser Voraussetzung problemlos durchgeführt werden.

Sollte vor der Strommessung kein Bremsvorgang erfolgt sein, so haben diese Vorsteuerimpulse keine nachteilige Wirkung.

## Patentansprüche

1. Verfahren zur Erfassung eines durch eine Last fließenden impulsförmigen Stromes, bei welchem als Meßimpuls ein Spannungsabfall über einen von dem impulsförmigen Strom durchflossenen Meßwiderstand ausgewertet wird **dadurch gekennzeichnet, dass** der Strom bipolare Stromrichtungen aufweist und vor Beginn der Strommessung mindestens ein Vorsteuerstromimpuls (V1, V2, V3) an dem aus einem magnetischen Material bestehenden Meßwiderstand (6) anliegt, welcher die Stromrichtung der während der Strommessung auftretenden Stromimpulse (Iₘₑₛₛ) aufweist, wobei die Amplitude des Vorsteuerstromimpulses (V1, V2, V3) annähernd einem Maximalwert des zu messenden Stromimpulses (Iₘₑₛₛ) entspricht und die Pulsbreite des Vorsteuerstromimpulses (V1, V2, V3) kleiner ist als die Pulsbreite des Meßimpulses (Uₘₑₛₛ).

2. Verfahren nach Anspruch 1 **dadurch gekennzeichnet, dass** die Pulsbreite des Vorstromimpulses (V1, V2, V3) kleiner ist als die Summe der ansteigenden und der abfallenden Flanke des von einem Endstufentreiber (13) ausgegebenen Impulses.

3. Verfahren nach Anspruch 1 **dadurch gekennzeichnet, dass** jeder Meßimpuls (Uₘₑₛₛ), welcher infolge des Vorstromimpulses (V1, V2, V3) oder des Meßstromimpulses (Iₘₑₛₛ) gemessen wird, integriert wird.

4. Verfahren nach Anspruch 1 oder 2 **dadurch gekennzeichnet, dass** mehrere Vorstromimpulse (V1, V2, V3) mit unterschiedlicher Impulsbreite erzeugt werden, wobei die Amplitude des letzten Vorstromimpulses (V3) dem Maximalwert des durch den Meßwiderstand fließenden Stromes entspricht.

5. Verfahren nach Anspruch 1 oder 2 **dadurch gekennzeichnet, dass** mehrere Vorstromimpulse (V1, V2, V3) annähernd die gleiche Impulsbreite und Amplitude aufweisen.

6. Verfahren nach Anspruch 3 **dadurch gekennzeichnet, dass** die Amplitude des Meßimpulses (Uₘₑₛₛ) zur Prüfung eines Fehlerfalles ausgewertet wird, wobei bei Feststellung des Fehlerfalles die Last (1) abgeschaltet wird.
